Europäisches Patentamt

European Patent Office

Office européen des brevets

(19)

(11) **EP 0 664 587 B1**

(12) **EUROPÄISCHE PATENTSCHRIFT**

(45) Veröffentlichungstag und Bekanntmachung des Hinweises auf die Patenterteilung:
**25.06.1997  Patentblatt 1997/26**

(51) Int Cl.$^6$: **H01S 3/085**, H01S 3/103

(21) Anmeldenummer: **95100087.6**

(22) Anmeldetag: **03.01.1995**

(54) **Abstimmbare Laserdiode**

Tunable laserdiode

Laser à diode accordable

(84) Benannte Vertragsstaaten:
**DE FR NL**

(30) Priorität: **19.01.1994  DE 4401444**

(43) Veröffentlichungstag der Anmeldung:
**26.07.1995   Patentblatt 1995/30**

(73) Patentinhaber: **SIEMENS AKTIENGESELLSCHAFT**
**80333 München (DE)**

(72) Erfinder: **Amann, Markus-Christian, Dr.**
**D-34225 Baunatal (DE)**

(56) Entgegenhaltungen:
**EP-A- 0 552 390          US-A- 4 054 363**

- **IEEE JOURNAL OF QUANTUM ELECTRONICS., Bd.QE-13, Nr.8, August 1977, NEW YORK US Seiten 619 - 622 Y. SUEMATSU ET AL 'Axial mode selectivities for various types of integrated twin-guide lasers'**
- **JOURNAL OF LIGHTWAVE TECHNOLOGY., Bd.11, Nr.7, Juli 1993, NEW YORK US Seiten 1168 - 1182 M.-C AMANN ET AL 'Tunable laser diodes utilizing transverse tuning scheme'**
- **ELECTRONICS LETTERS., Bd.30, Nr.24, 24. November 1994, STEVENAGE, HERTS, GB Seiten 2047 - 2049 B. BORCHERT ET AL 'Vertically integrated Mach-zehnder interferometer (VMZ) widely tunable laser diode with improved wavelength acces.'**

**Beschreibung**

Die vorliegende Erfindung betrifft eine abstimmbare Halbleiterlaserdiode.

Für fortgeschrittene optische Kommunikationssysteme sind Laserlichtquellen erforderlich, die über einen weiten Bereich hin abstimmbar sind. Bei derartigen Laserdioden sind einfache Betriebsweise und ein breiter Abstimmbereich erforderlich. In der Veröffentlichung von S. Illek et al.: "Codirectionally Coupled Twin-Guide Laser Diode for Broadband Electronic Wavelength Tuning" in Electronics Letters 27, 2207 bis 2208 (1991) ist eine als ACA-Laser bezeichnete abstimmbare Laserdiode beschrieben, die in der Länge in einen Verstärker-, einen Koppler- und einen Absorberbereich aufgeteilt ist. Zwei Wellenleiter sind vertikal zueinander und durch eine Mantelschicht voneinander getrennt angeordnet. In dem oberen Wellenleiter wird Licht erzeugt und verstärkt, das in einer ersten Mode sich ausbreitet. In dem Kopplerbereich wird diese Welle in den unteren Wellenleiter gekoppelt. Der Absorberbereich verhindert die Abstrahlung der Mode in dem oberen Wellenleiter. Laserbetrieb wird möglich durch den Austausch der Strahlungsleistung zwischen den beiden in den beiden Wellenleitern geführten Moden.

In der Veröffentlichung von I. Kim et al.: "Broadly Tunable InGaAsP/InP Vertical-Coupler Filtered Laser With Low Tuning Current" in Electronics Letters 29, 664 bis 666 (1993) ist eine VCF-Laserdiode beschrieben, bei der hintereinander ein Verstarkerbereich, ein Kopplerbereich und ein sogenannter Fensterbereich angeordnet sind. Der Verstärkerbereich und der Kopplerbereich besitzen separate Stromanschlüsse. Der Verstärkerbereich besitzt eine Quantumwell-Schichtstruktur. Bei beiden in den genannten Veröffentlichungen beschriebenen Strukturen ist die Unterdrückung von longitudinalen Seitenmoden relativ gering, da die wellenlängenselektive Filterung und Abstimmung nur in einem Teilbereich der gesamten Laserdiode erfolgt. Dies kann zu einer ungenügenden und instabilen Einmodenemission führen.

Dieses Problem kann im wesentlichen dadurch vermieden werden, daß die Filterung auf die gesamte Laserlänge verteilt wird, wie z. B. in der DFC-Laser-Struktur aus der Veröffentlichung von M.-C. Amann et al.: "Widely Tunable Distributed Forward Coupled (DFC) Laser" in Electronics Letters 29, 793 bis 794 (1993). Bei dieser Struktur sind ebenfalls zwei Wellenleiter vertikal zueinander angeordnet und verkoppelt. In Längsrichtung sind vertikal dazu Absorptionsbereiche angeordnet, die ein filterndes Gitter in Längsrichtung bilden. Diese Diode wurde zum Patent angemeldet (EP 0 552 390 A1).

In der Veröffentlichung von Y. Suematsu et al.: "Axial-Mode Selectivities for Various Types of Integrated Twin-Guide Lasers" in IEEE Journal of Quantum Electronics Vol. QE-13, 619 bis 622 (1977) ist eine ITG-Laserdiode beschrieben, bei der übereinander ein längerer und ein kürzerer Wellenleiter als Laserresonator angeordnet sind. In dem Bereich, in dem beide Wellenleiter übereinander vorhanden sind, findet eine Kopplung der darin geführten Moden statt.

Ein anderer Lösungsansatz zur Unterdrückung von Seitenmoden ist in der Veröffentlichung von M. Öberg et al.: "74 nm Wavelength Tuning Range of an InGaAsP/InP Vertical Grating Assisted Codirectional Coupler Laser with Rear Sampled Grating Reflector" in IEEE Photonics Technology Letters 5, 735 bis 738 (1993) beschrieben. Hierbei werden die Funktionen Filterung und Abstimmung voneinander getrennt und separat optimiert. Zur breitbandigen Abstimmung wird wie in den oben beschriebenen Lasern die kodirektionale Modenkopplung mit ihrer relativ geringen spektralen Filterung der (spektral nahegelegenen) Seitenmoden verwendet. Die Fernselektion für spektral weiter entfernte Moden ist bei der kodirektionalen Modenkopplung (insbesondere falls die Kopplerlänge einer Koppellänge entspricht) gut. Eine starke Unterdrückung der Seitenmoden wird deshalb durch den zusätzlichen Einsatz einer speziellen Bragg-Gitter-Struktur als Laserendspiegel erreicht. Die gute Nahselektion dieses speziellen Bragg-Gitters wird jedoch mit einer schlechten Fernselektion (Vieldeutigkeit) erkauft. Aufgrund der guten Fernselektion des kodirektionalen Kopplers bedeutet dies jedoch keine Verschlechterung der Betriebseigenschaften der gesamten Laser struktur. Der wesentliche Nachteil dieser Kombination ist neben der relativ großen Länge die kritische Synchronisation der Filterfunktion mit der Abstimmfunktion, was eine sehr genaue Justierung von zwei Steuerströmen bedeutet und die praktische Handhabung entscheidend beeinträchtigt.

Aufgabe der vorliegenden Erfindung ist es, eine technologisch möglichst einfache und möglichst kurze Laserdiode anzugeben, die über einen sehr großen Wellenlängenbereich mit nur einem Abstimmstrom eindeutig, reproduzierbar und weitgehend einmodig abstimmbar ist.

Diese Aufgabe wird mit der Laserdiode des Anspruches 1 gelöst. Weitere Ausgestaltungen ergeben sich aus den abhängigen Ansprüchen.

Bei der erfindungsgemäßen Laserdiode werden die Filter- und Abstimmfunktion nicht voneinander getrennt, aber es wird trotzdem erreicht, daß Nah- und Fernselektion getrennt optimiert werden können. Aufgrund der Selbstjustierung innerhalb dieser Laserdiode wird nur ein Steuerstrom benötigt. Die Kombination von Filterung und Abstimmung in einer Funktionseinheit ermöglicht es außerdem, extrem kurze Bauelemente herzustellen. Typische Längen der erfindungsgemäßen Laserdiode betragen deshalb 200 bis 600 μm, wohingegen bei Bauelementen mit getrennter Optimierung von Nah- und Fernselektion, die bisher bekannt sind, die Gesamtstruktur üblicherweise einige mm lang sein muß. Die Funktionsweise des erfindungsgemäßen Lasers beruht auf dem Prinzip des Mach-Zehnder-Interferometers, welches in die Laserdiode vertikal integriert wird. Im folgenden wird daher die Abkürzung VMZ-Laser benutzt.

Bei dem VMZ-Laser ist vertikal zu einem für die Führung des Laserlichts vorgesehenen Wellenleiter ein weiterer damit verkoppelter Wellenleiter angeordnet. Dieser weitere Wellenleiter ist nur in einem Teilabschnitt der Gesamtlänge der Laserdiode vorhanden. Durch die Verkopplung der in den beiden Wellenleitern ausbreitungsfähigen Moden wird die Filterwirkung hervorgerufen. Durch die Ausbildung des zweiten Wellenleiters in mehreren Abschnitten unterschiedlicher Länge wird sowohl eine gute Nahselektion als auch eine gute Fernselektion erreicht.

Es folgt eine Beschreibung der VMZ-Laserdiode anhand der Figuren 1 bis 8.

Fig. 1 bis 4   zeigen verschiedene Ausführungsbeispiele der VMZ-Laserdiode im Längsschnitt, von denen die in Fig. 3 und 4 dargestellten Laserdioden Ausführungsformen der Erfindung sind.

Fig. 5   zeigt Filterkurven für verschiedene Ausführungsformen.

Fig. 6   zeigt die Schichtstruktur einer Ausführungsform im Längsschnitt.

Fig. 7 und 8   zeigen die in Fig. 6 bezeichneten Querschnitte.

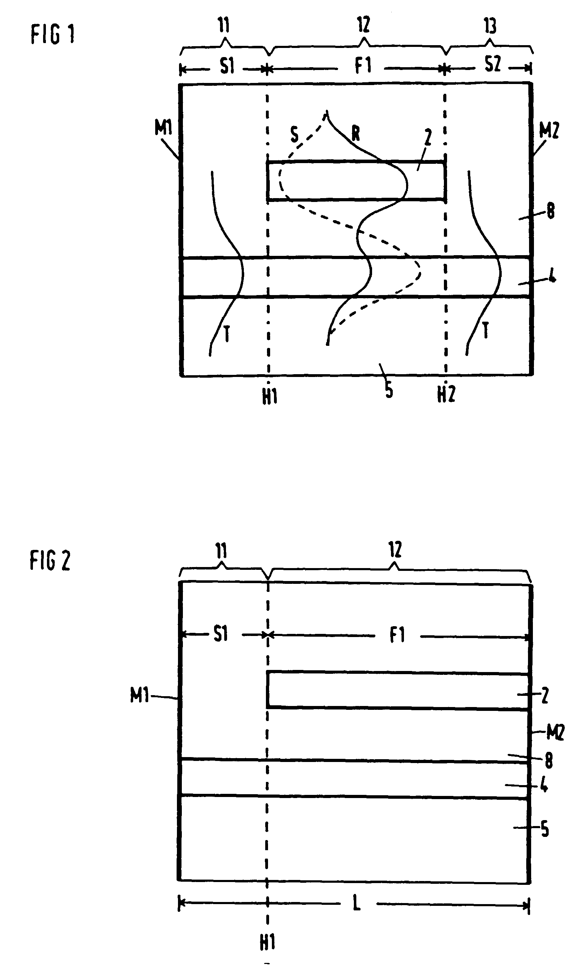

Bei der einfachsten Ausführungsform des VMZ-Lasers, die in einem schematischen Längsschnitt in Fig. 1 gezeigt ist, ist der Laserresonator in der Länge in drei Sektionen eingeteilt. Aufeinanderfolgend sind diese Sektionen: Ein erster Einfach-Bereich 11 der Länge S1, ein Doppel-Bereich 12 der Länge F1 und ein zweiter Einfach-Bereich 13 der Länge S2. In den Einfach-Bereichen ist jeweils nur ein Wellenleiter 4 vorhanden, in dem nur ein transversaler Mode (Mode T) ausbreitungsfähig ist. In dem für die Filterung vorgesehenen Doppel-Bereich 12 ist ein weiterer Wellenleiter 2 vertikal parallel zu dem ersten Wellenleiter 4 angeordnet. In diesem Doppel-Bereich 12 sind zwei geführte Moden R und S ausbreitungsfähig. In der einfachen Darstellung der Fig. 1 ist der über die gesamte Länge des Bauelementes vorhandene Wellenleiter 4 auf einer unteren Mantelschicht oder einem Substrat 5 aufgebracht. Dieser Wellenleiter 4 ist in eine Mantelschicht 8 vergraben, in der der zweite Wellenleiter 2 eingebettet ist. An den Grenzebenen H1, H2 wird der Mode T der Einfach-Bereiche 11, 13 mit den beiden Moden R und S des Doppel-Bereiches 12 verkoppelt.

Da die beiden Moden R und S unterschiedliche Phasengeschwindigkeiten besitzen (unterschiedliche effektive Brechzahlen, Differenz der effektiven Brechzahlen ca. 0,1) ist eine konstruktive Interferenz der durch Mode T an der Grenzfläche H1 angeregten Moden R und S an der Grenzfläche H2 bei der erneuten Kopplung in Mode T nur bei bestimmten diskreten Wellenlängen möglich. Für die Angabe dieser Wellenlängen ist die Koppellänge maßgeblich. Konstruktive Interferenz ergibt sich, wenn die Länge F1 des Doppel-Bereiches 12 ein ganzzahliges Vielfaches der Koppellänge ist. Da die Koppellänge gleich dem Quotienten aus Wellenlänge und Differenz der effektiven Brechzahlen ist, ergeben sich die Wellenlängen der konstruktiven Interferenz als ganzzahliger Bruch des Produktes aus Länge F1 des Doppel-Bereiches 12 und der Differenz der effektiven Brechzahlen:

$$\lambda = F1 \times (n1 - n2)/N,$$

wobei n1 und n2 die effektiven Brechzahlen sind und N eine natürliche Zahl.

Wenn N sehr groß ist, liegen diese resonanten Wellenlängen sehr dicht und etwa im gleichen Abstand (bei vernachlässigbarer Dispersion der effektiven Brechzahlen) beieinander. Wenn die Länge F1 sehr groß ist, kann daher die Nahselektion in der unmittelbaren Umgebung einer ausgewählten resonanten Wellenlänge sehr hoch sein, während andererseits aufgrund der Vieldeutigkeit der Filterkurve eine Verschlechterung der Fernselektion eintritt.

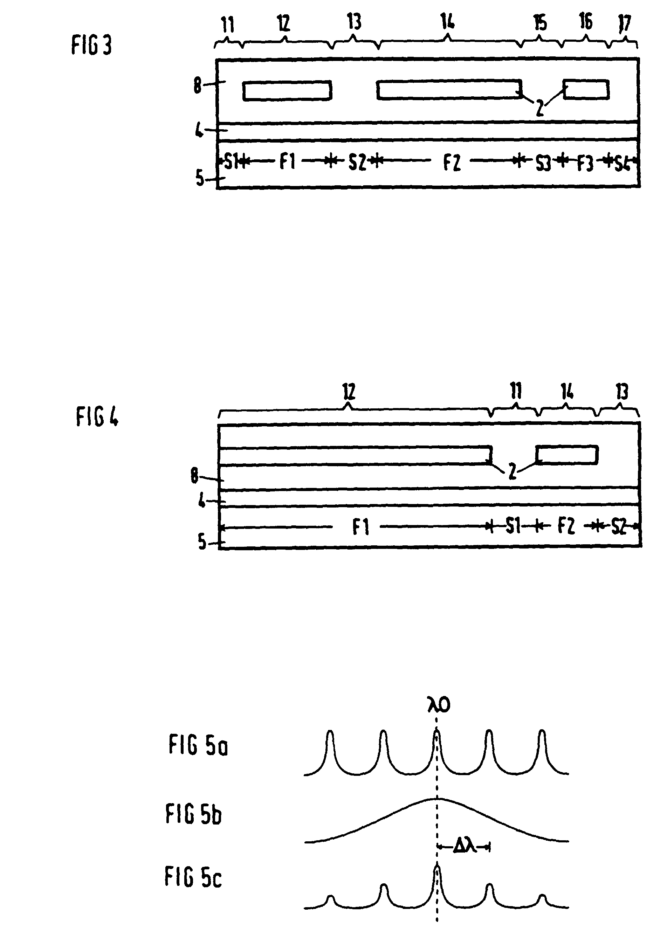

Diese Eigenschaften sind anhand der Fig. 5, die die prinzipielle Form der Filterkurven darstellt, veranschaulicht. Fig. 5a zeigt den Verlauf der Übertragungscharakteristik (Filterkurve) im Wellenlängenbereich um eine bestimmte resonante Wellenlänge $\lambda_0$ für ein sehr großes N (z. B. N = 20). Für N = 1 ist der Verlauf der Filterkurve im Schema in Fig. 5b dargestellt. Der flachere Verlauf des Resonanzmaximums in diesem Fall zieht eine geringe Selektion der nächstgelegenen Wellenlängen nach sich. Die Fernselektion ist aber wesentlich größer als in dem Beispiel der Filterkurve der Fig. 5a. Bei der VMZ-Laserdiode erfolgt die Abstimmung der Wellenlänge durch eine Veränderung der Differenz der effektiven Brechzahlen mittels Ladungsträgerinjektion in einen der Wellenleiter 2, 4 in dem Doppel-Bereich 12. Zu diesem Zweck sind elektrische Kontakte an den Oberseiten der Diode angebracht und die Bereiche der Mantelschicht 8 derart dotiert, daß separat in die beiden Wellenleiter 2, 4 Ströme injiziert werden können. Der gesamte Laserresonator wird wie in Fig. 1 dargestellt durch die Laserendspiegel M1, M2 begrenzt.

Mit der entsprechend Fig. 2 abgewandelten Struktur ist eine ca. 3 dB größere Nahselektion möglich, da hier die Länge F1 des Doppel-Bereiches 12 wegen der Reflexion der Strahlung am rechten Resonatorendspiegel M2 effektiv verdoppelt wird. Eine gleichzeitige Optimierung hinsichtlich der Nah- und Fernselektion ist durch Hintereinanderschaltung mehrerer Filterbereiche unterschiedlicher Länge möglich, wie das schematisch in den Fig. 3 und 4 dargestellt ist. In der Fig. 3 sind ein erster Einfach-Bereich 11, ein zweiter Einfach-Bereich 13, ein dritter Einfach-Bereich 15 und ein vierter Einfach-Bereich 17 der jeweiligen Längen S1, S2, S3 und S4 dargestellt, die jeweils durch einen ersten Doppel-Bereich 12, einen zweiten Doppel-Bereich 14 und einen dritten Doppel-Bereich 16 der jeweiligen Längen F1, F2 und F3 unterbrochen sind. Der für die Verkopplung vorgesehene zweite Wellenleiter 2 ist dementsprechend in Längsrichtung in Abschnitte der Längen F1, F2 und F3 unterteilt, die jeweils in die Mantelschicht 8 eingebettet sind. Wegen der unterschiedlichen Längen dieser verschiedenen Abschnitte wird eine gute Selektion einer einzigen Wellenlänge aus dem Gesamtspektrum erreicht. In der in Fig. 4 dargestellten Struktur sind ein erster Doppel-Bereich 12 besonders großer Länge F1 und ein zweiter Doppel-Bereich 14 einer wesentlich geringeren Länge F2 vorgesehen. Damit ergibt sich eine Kombination der guten Nahselektion, wie sie die Filterkurve der Fig. 5a darstellt, mit der guten Fernselektion, wie sie die Filterkurve der Fig. 5b darstellt. Damit erreicht man für diese Ausführungsform der Fig. 4 als Übertragungscharakteristik die Filterkurve der Fig. 5c. Es ist dabei von besonderer Bedeutung, daß bei der gemeinsamen Kontaktierung der verschiedenen Sektionen eine gleichmäßige und gleich starke Abstimmung auftritt, so daß sich die beiden Filterkurven ohne weitere Maßnahmen prinzipiell synchron gemeinsam auf der Wellenlängenskala verschieben, wenn die Wellenlänge durch Ändern des Abstimmstromes geändert wird. Das stellt eine entscheidende Vereinfachung bei der Handhabung der VMZ-Laserdiode dar (insbesondere im Vergleich zu der Struktur, die in der eingangs erwähnten Veröffentlichung von Öberg et al. beschrieben ist), da sich der Anwender nicht um die gegenseitige Justierung von Nah- und Fernselektion kümmern muß.

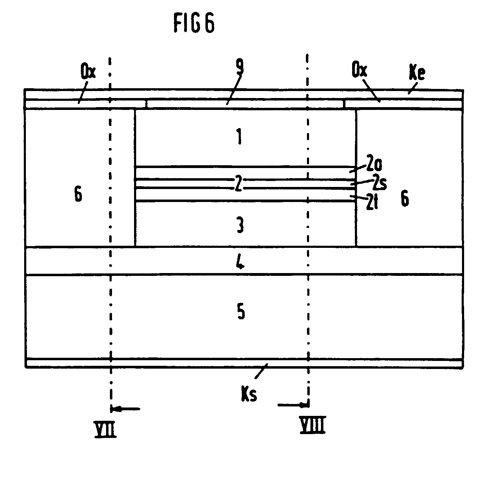

Die Schichtstruktur einer praktischen Ausführungsform des VM-Z-Lasers wird anhand der Figuren 6 bis 8 und der beigefügten Tabellen beschrieben. In Fig. 6 ist der Längsschnitt einer VMZ-Laserdiode entsprechend dem Ausführungsbeispiel der Fig. 1 dargestellt. Auf ein Substrat 5 oder die oberste Schicht einer epitaktisch überwachsenen Halbleiterscheibe ist der Wellenleiter 4 als streifenförmige Schicht aufgebracht. Auf diesem Wellenleiter 4 ist in dem für die Kopplung vorgesehenen Abschnitt (Doppel-Bereich) der weitere Wellenleiter 2 vorhanden, der zwischen Mantelschichten 1, 3 eingebettet ist. Die Abschnitte außerhalb der Koppelbereiche (Einfach-Bereiche) sind mit Mantelschichten 6 aufgefüllt. Bei der Ausführungsform der Fig. 6 ist der weitere Wellenleiter 2 dreilagig ausgebildet und umfaßt eine aktive Schicht 2a, eine Trennschicht 2s und eine Abstimmschicht 2t. Die Abstimmschicht kann alternativ auf der dem Substrat abgewandten Seite der Trennschicht angeordnet sein. Die aktive Schicht befindet sich dann zwischen der Trennschicht und dem Substrat. Dadurch, daß die aktive Schicht und die Abstimmschicht zusammen in einem der Wellenleiter angeordnet sind, ergeben sich hervorragende Abstimmeigenschaften, weil sich der Abstimmbereich durch die Wechselwirkung (über die durch die Abstimmung erzeugten optischen Verluste) zwischen der Abstimmschicht und der aktiven Schicht in diesem Fall um ca. 30 bis 50 % vergrößert. Statt dessen ist es auch möglich, beide Wellenleiter einlagig auszubilden, wobei dann der eine Wellenleiter die aktive Schicht und der andere Wellenleiter die Abstimmschicht darstellt. Die Wellenleiter 2, 4 können auch als Quantumwell-Schichten oder Multi-Quantum-well-Schichten hergestellt sein.

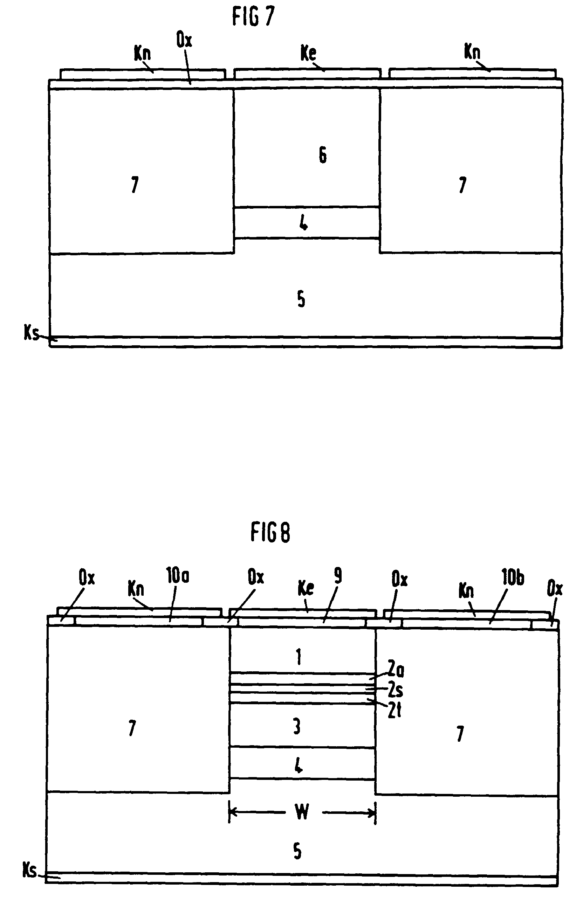

Die in Fig. 6 eingezeichneten Schnittansichten sind in den Figuren 7 und 8 dargestellt. In den Fig. 7 und 8 sind die lateralen Mantelschichten 7, die den streifenförmigen Schichtaufbau des Doppelwellenleiters begrenzen, eingezeichnet. Auf den verschiedenen Bereichen der Mantelschichten sind jeweils hoch dotierte Kontaktschichten 9, 10a, 10b aufgebracht. Das übrige Halbleitermaterial ist so dotiert, daß die Mantelschicht 1, die Mantelschicht 3, der Wellenleiter 4, das Substrat 5 und die Kontaktschicht 9 auf der Mantelschicht 1 für elektrische Leitung eines ersten Leitfähigkeitstyps dotiert sind. Die Trennschicht 2s, die obere Mantelschicht 6 in den Einfach-Bereichen, die lateralen Mantelschichten 7 und die Kontaktschichten 10a und 10b auf den lateralen Mantelschichten 7 sind für elektrische Leitung des entgegengesetzten Leitfähigkeitstyps dotiert. Vorteilhaft ist der erste Leitfähigkeitstyp z. B. p-Leitung und der zweite Leitfähigkeitstyp n-Leitung. Auf den Kontaktschichten 9, 10 und auf dem Substrat 5 sind die jeweiligen Kontakte Ke, Kn, Ks für den elektrischen Anschluß nach außen aufgebracht. Der Bereich zwischen den Kontaktschichten auf der Oberseite kann durch eine Oxidschicht Ox planarisiert sein.

Typische Materialzusammensetzungen und Dotierungen sowie die Dicken der einzelnen Schichten sind für ein Ausführungsbeispiel im Materialsystem von InP in der Tabelle 1, die beigefügt ist, angegeben. In dem Fall, daß die aktive Schicht und die Abstimmschicht je durch einen der beiden Wellenleiter 2, 4 gegeben ist, muß entsprechend die dazwischen befindliche Mantelschicht 3 für dem Substrat 5 und der oberen Mantelschicht 1 entgegengesetzten Leitfähigkeitstyp dotiert werden. Die Mantelschicht 3 ist dann also n-InP, und die Wellenleiter 2, 4 sind undotiertes InGaAsP. Weitere Parameter des beschriebenen Ausführungsbeispiels sind im Anschluß an Tabelle 1 angegeben. In Tabelle 2 sind typische Längenabmessungen, der Abstand der resonanten Wellenlängen und der Abstimmbereich für die Ausführungsformen der Figuren 1, 2 und 4 aufgelistet. In Tabelle 1 ist zu den angegebenen Bereichen jeweils in Klammern ein typischer Wert angegeben.

In den Ansprüchen sind alle Doppel-Bereiche, in denen jeweils zwei Wellenleiter vertikal zueinander vorhanden sind, gemeinsam als Koppelbereich bezeichnet. Je nach Ausführungsform der VMZ-Laserdiode kann dieser Koppelbereich einen oder mehrere zusammenhängende Abschnitte aufweisen. Bei der einfachsten Ausführungsform ist der untere Wellenleiter 4 direkt auf ein Substrat 5 aufgebracht. Statt eines Substrates kann diese Halbleiterschicht auch eine untere Mantelschicht 5 sein. Falls die aktive Schicht oder die Abstimmschicht in dem unteren Wellenleiter 4 ausgebildet ist und für die Stromzuführung in diese untere Wellenleiterschicht 4 eine dotierte untere Mantelschicht 5 vorhanden ist, kann der zugehörige Anschlußkontakt auf der Oberseite aufgebracht sein, so daß auch ein semiisolierendes Substrat verwendet werden kann. Die für die getrennte Strominjektion in die aktive Schicht und die Abstimmschicht vorgesehenen Maßnahmen entsprechen denen der bekannten TTG-Laserdiode, insbesondere der eingangs erwähnten ACA-Laserdiode.

Tabelle 1:

| Nr.: | Material | λg (µm) | Dotierung (10^17cm^-3) | Dicke (µm) | Funktion |
|---|---|---|---|---|---|
| 1 | p-InP | 0.92 | 1-10 (5) | 1-3 (2) | Mantelschicht |
| 2a | InGaAsP | 1.56 | 0-10 (0) | 0.05-0.3 (0.15) | aktive Schicht |
| 2s | n-InP | 0.92 | 5-50 (20) | 0.05 | Trennschicht |
| 2t | InGaAsP | 1.35 | 0-20 (0) | 0.05-0.4 (0.2) | Abstimmschicht |
| 3 | p-InP | 0.92 | 2-20 (5) | 0.1-0.5 (0.3) | Mantelschicht |
| 4 | p-InGaAsP | 1.05 | 1-5 (2) | 0.1-0.7 (0.5) | Wellenleiter |
| 5 | p-InP | 0.92 | 5-20 (10) | 50-200 (100) | Substrat |
| 6 & 7 & 8 | n-InP | 0.92 | 5-50 (10) | 0.5-5 (3.5) | Mantelschicht |
| 9 | p-InGaAsP | 1.3 | 100-1000 (500) | 0.03-0.5 (0.2) | Kontaktschicht |
| 10a & 10b | n-InGaAsP | 1.1-1.67 (1.67) | 10-500 (200) | 0.03-0.5 (0.2) | Kontaktschicht |
| Ox | Oxid (Al,Si) | - | - | 0.03-0.3 (0.2) | Isolation |
| Ks & Ke | Ti/Pt/Au | - | - | 0.2-1 (0.5) | p-Kontakt |
| Kn | Ti/Pt/Au | - | - | 0.2-1 (0.5) | n-Kontakt |
| Wellenlänge: 1.5 µm<br>Streifenbreite W: 1-2 µm<br>eff. Indexdifferenz zwischen Mode R und S: ca. 0.1<br>Grundperiode Λ: 15 µm<br>Dispersion β: 2<br>optischer Confinementfaktor in Abstimmschicht: ca. 30% | | | | | |

Tabelle 2:

| Typ nach Bild Nr.: | Gesamtlänge L (µm) | F1 (µm) | F2 (µm) | S1 (µm) | S2 (µm) | Δλ (nm) | Abstimm-Bereich (nm) |
|---|---|---|---|---|---|---|---|
| 1 | 200 | 180 | - | 10 | 10 | 66 | 66 |
| 2 | 200 | 180 | - | 20 | - | 33 | 33 |
| 4 | 200 | 150 | 30 | 10 | 10 | 37.5 | 67.5 |

**Patentansprüche**

1.  Abstimmbare Laserdiode,

    bei der zwei als Schichten ausgebildete Wellenleiter (2, 4) bezüglich der Schichtebene vertikal übereinander und durch eine Mantelschicht (3) voneinander getrennt so dicht benachbart zueinander angeordnet sind, daß eine Modenkopplung zwischen diesen Wellenleitern (2, 4) auftritt,

    bei der einer dieser Wellenleiter (2) nur in einem Koppelbereich vorhanden ist, der nicht die gesamte Länge eines als Resonator vorgesehenen Abschnitts der Laserdiode umfaßt, bei der diese Wellenleiter (2, 4) solche Abmessungen und Materialzusammensetzungen aufweisen, daß in diesem Koppelbereich eine Verkopplung zweier unterschiedlicher Moden stattfindet,

    bei der der Koppelbereich mehrere zusammenhängende Abschnitte (12, 14, 16) hat, welche unterschiedliche Längen haben, die jeweils natürliche Vielfache der Koppellänge der zu verkoppelnden Moden sind,

    bei der in diesen Wellenleitern (2, 4) in diesem Koppelbereich eine aktive Schicht und eine Abstimmschicht bezüglich der Schichtebene vertikal zueinander angeordnet vorhanden sind und

    bei der Mittel vorhanden sind, mit denen in diese aktive Schicht und in diese Abstimmschicht getrennt voneinander Strom injiziert werden kann.

**2.** Laserdiode nach Anspruch 1,

bei der die aktive Schicht durch einen der Wellenleiter und die Abstimmschicht durch den anderen Wellenleiter gebildet ist,

bei der die zwischen den Wellenleitern befindliche Mantelschicht (3) für elektrisch Leitung eines ersten Leitfähigkeitstyps dotiert ist,

bei der Halbleiterschichten auf der jeweils dieser Mantelschicht (3) abgewandten Seite der Wellenleiter für elektrische Leitung des entgegengesetzten Leitfähigkeitstyps dotiert sind und

bei der Kontakte (Ke, Kn, Ks) vorhanden sind, die mit dieser Mantelschicht (3) und diesen Halbleiterschichten jeweils elektrisch leitend verbunden sind, so daß eine getrennte Strominjektion in die beiden Wellenleiter (2, 4) möglich ist.

**3.** Laserdiode nach Anspruch 1,

bei der die aktive Schicht (2a) und die Abstimmschicht (2t) durch eine mehrlagige Schichtstruktur in einem der Wellenleiter (2) ausgebildet sind,

bei der diese Schichtstruktur eine Trennschicht (2s) zwischen dieser aktiven Schicht (2a) und dieser Abstimmschicht (2t) umfaßt,

bei der diese Trennschicht (2s) für elektrische Leitung eines ersten Leitfähigkeitstyps dotiert ist,

bei der Halbleiterschichten auf der jeweils dieser Trennschicht (2s) abgewandten Seite der aktiven Schicht (2a) und

der Abstimmschicht (2t) für elektrische Leitung des entgegengesetzten Leitfähigkeitstyps dotiert sind und

bei der Kontakte (Ke, Kn, Ks) vorhanden sind, die mit dieser Trennschicht (2s) und diesen Halbleiterschichten jeweils elektrisch leitend verbunden sind, so daß eine getrennte Strominjektion in die aktive Schicht (2a) und die Abstimmschicht (2t) möglich ist.

**4.** Laserdiode nach einem der Ansprüche 1 bis 3,

bei der die Mantelschichten (1, 3, 5, 6, 7) InP sind,

bei der die Wellenleiter (2, 4) zumindest Schichtanteile aus InGaAsP aufweisen und

bei der die beiden Wellenleiter (2, 4) unterschiedliche Zusammensetzungen haben.

**5.** Laserdiode nach einem der Ansprüche 1 bis 4,

bei der auf einer unteren Mantelschicht (5) ein Wellenleiter (4) streifenförmig und über die gesamte Länge des als Laserresonator vorgesehenen Abschnitts vorhanden ist,

bei der auf diesem Wellenleiter (4) eine Mantelschicht (3, 6) vorhanden ist,

bei der auf dieser Mantelschicht (3) der weitere Wellenleiter (2) streifenförmig vorhanden ist,

bei der dieser weitere Wellenleiter (2) parallel und bezüglich der Schichtstruktur vertikal zu dem ersten Wellenleiter (4) angeordnet und nicht über dessen gesamte Länge vorhanden ist,

bei der auf diesem weiteren Wellenleiter (2) eine obere Mantelschicht (1) vorhanden ist,

bei der diese Wellenleiter (2, 4) sich zwischen lateralen Mantelschichten (7) befinden,

bei der auf der oberen Mantelschicht (1) und auf den lateralen Mantelschichten (7) hoch dotierte Kontaktschichten (9, 10a, 10b) aufgebracht sind,

bei der Kontakte (Ke, Kn, Ks) aufgebracht sind und

bei der diese Mantelschichten (1, 3, 5, 6, 7) derart für elektrische Leitung dotiert sind, daß diese Kontakte (Ke, Kn, Ks) so mit den vertikal zu den Wellenleitern (2, 4) vorhandenen Mantelschichten (1, 3, 5, 6) elektrisch leitend verbunden sind, daß in eine in einem dieser Wellenleiter (2, 4) ausgebildete aktive Schicht und eine in einem dieser Wellenleiter (2, 4) ausgebildete Abstimmschicht getrennt Ströme injiziert werden können.

**6.** Laserdiode nach Anspruch 5, rückbezogen auf Anspruch 4,

bei der die aktive Schicht (2a) und die Abstimmschicht (2t) durch eine Trennschicht (2s) getrennt in einem der Wellenleiter (2) ausgebildet sind,

bei der die obere Mantelschicht (1) p-leitend dotiert ist mit einer Dotierungsdichte von $10^{17}$ cm$^{-3}$ bis $10^{18}$ cm$^{-3}$,

bei der die aktive Schicht (2a) höchstens eine Dotierungsdichte von $10^{18}$ cm$^{-3}$ hat,

bei der die Trennschicht (2s) n-leitend dotiert ist mit einer Dotierungsdichte von 5 x $10^{17}$ cm$^{-3}$ bis 5 x $10^{18}$ cm$^{-3}$,

bei der die Abstimmschicht (2t) höchstens eine Dotierungsdichte von 2 x $10^{18}$ cm$^{-3}$ hat,

bei der die Mantelschicht (3) zwischen den Wellenleitern (2, 4) p-leitend dotiert ist mit einer Dotierungsdichte von $2 \times 10^{17}$ cm$^{-3}$ bis $2 \times 10^{18}$ cm$^{-3}$,

bei der der Wellenleiter (4), der nicht die aktive Schicht (2a) enthält, p-leitend dotiert ist mit einer Dotierungsdichte von $10^{17}$ cm$^{-3}$ bis $5 \times 10^{17}$cm$^{-3}$,

bei der die untere Mantelschicht (5) p-leitend dotiert ist mit einer Dotierungsdichte von $5 \times 10^{17}$ cm$^{-3}$ bis $2 \times 10^{18}$ cm$^{-3}$ und

bei der die übrigen Mantelschichten (6, 7) n-leitend dotiert sind mit einer Dotierungsdichte von $5 \times 10^{17}$ cm$^{-3}$ bis $5 \times 10^{18}$ cm$^{-3}$.

7. Laserdiode nach Anspruch 6,

bei der die obere Mantelschicht (1) 1 μm bis 3 μm dick ist,
bei der die aktive Schicht (2a) 0,05 μm bis 0,3 μm dick ist,
bei der die Abstimmschicht (2t) 0,05 μm bis 0,4 μm dick ist,
bei der die Mantelschicht (3) zwischen den Wellenleitern (2, 4) 0,1 μm bis 0,5 μm dick ist und
bei der der Wellenleiter (4), der nicht die aktive Schicht (2a) enthält, 0,1 μm bis 0,7 μm dick ist.

8. Laserdiode nach einem der Ansprüche 1 bis 7,

bei der der Wellenleiter (2), der nur in einem Koppelbereich vorhanden ist, einen zusammenhängenden Abschnitt aufweist,
der mindestens drei Viertel der Länge des Laserresonators besitzt.

## Claims

1. Tunable laser diode, in which two waveguides (2, 4) constructed as layers are arranged, in a fashion above one another vertically with respect to the layer plane and separated from one another by a cladding layer (3), so closely adjacent to one another that mode coupling occurs between these waveguides (2, 4), in which one of these waveguides (2) is present only in a coupling region which does not comprise the entire length of a section of the laser diode provided as a resonator, in which these waveguides (2, 4) have dimensions and material combinations such that a coupling of two different modes occurs in this coupling region, in which the coupling region has a plurality of interconnected sections (12, 14, 16) which have different lengths which are in each case natural multiples of the coupling length of the modes to be coupled, in which an active layer and a tuning layer are present in these waveguides (2, 4) in this coupling region in a fashion arranged vertically one above another with respect to the layer plane, and in which means are provided with the aid of which current can be injected into this active layer and into this tuning layer separately from one another.

2. Laser diode according to Claim 1, in which the active layer is formed by one of the waveguides and the tuning layer is formed by the other waveguide, in which the cladding layer (3) located between the waveguides is doped for electric conduction of a first conductivity type, in which the semiconductor layers on the side of the waveguide respectively averted from this cladding layer (3) are doped for electric conduction of the opposite conductivity type, and in which contacts (Ke, Kn, Ks) are present which are connected in each case in an electrically conductive fashion to this cladding layer (3) and these semiconductor layers, with the result that a separate current injection is possible into the two waveguides (2, 4).

3. Laser diode according to Claim 1, in which the active layer (2a) and the tuning layer (2t) are formed by a multi-layer layer structure in one of the waveguides (2), in that this layer structure comprises a parting layer (2s) between this active layer (2a) and this tuning layer (2t), in which this parting layer (2s) is doped for electric conduction of a first conductivity type, in which semiconductor layers on the side of the active layer (2a) respectively averted from this parting layer (2s), and the tuning layer (2t), are doped for electric conduction of the opposite conductivity type, and in which contacts (Ke, Kn, Ks) are present which are respectively connected in an electrically conductive fashion to this parting layer (2s) and these semiconductor layers, with the result that a separate current injection into the active layer (2a) and the tuning layer (2t) is possible.

4. Laser diode according to one of Claims 1 to 3, in which the cladding layers (1, 3, 5, 6, 7) are InP, in which the waveguides (2, 4) have at least layer portions made from InGaAsP, and in that the two waveguides (2, 4) have different compositions.

5. Laser diode according to one of Claims 1 to 4, in which a waveguide (4) is present on a lower cladding layer (5) in the form of a strip and over the entire length of the section provided as laser resonator, in which a cladding layer (3, 6) is present on this waveguide (4), in which the further waveguide (2) is present in the form of a strip on this cladding layer (3), in which this further waveguide (2) is arranged parallel to the first waveguide (4) and vertically with respect to the layer structure, and is not present over the entire length of this first waveguide, in which an upper cladding layer (1) is present on this further waveguide (2), in which these waveguides (2, 4) are located between lateral cladding layers (7), in which highly doped contact layers (9, 10a, 10b) are applied on the upper cladding layer (1) and on the lateral cladding layers (7), in which contacts (Ke, Kn, Ks) are applied, and in which these cladding layers (1, 3, 5, 6, 7) are doped for electric conduction in such a way that these contacts (Ke, Kn, Ks) are connected in an electrically conductive fashion to the cladding layers (1, 3, 5, 6), which are present in a fashion vertical to the waveguides (2, 4), such that currents can be injected separately into an active layer formed in one of these waveguides (2, 4) and into a tuning layer formed in one of these waveguides (2, 4).

6. Laser diode according to Claim 5, with reference back to Claim 4, in which the active layer (2a) and the tuning layer (2t) are formed in one of the waveguides (2) in a fashion separated by a parting layer (2s), in which the upper cladding layer (1) is doped in a p-conductive fashion with a doping density of $10^{17}$ cm$^{-3}$ to $10^{18}$ cm$^{-3}$, in which the active layer (2a) has a doping density of at most $10^{18}$ cm$^{-3}$, in which the parting layer (2s) is doped in an n-conductive fashion with a doping density of $5 \times 10^{17}$ cm$^{-3}$ to $5 \times 10^{18}$ cm$^{-3}$, in which the tuning layer (2t) has a doping density of at most $2 \times 10^{18}$ cm$^{-3}$, in which the cladding layer (3) between the waveguides (2, 4) is doped in a p-conductive fashion with a doping density of $2 \times 10^{17}$ cm$^{-3}$ to $2 \times 10^{18}$ cm$^{-3}$,
in which the waveguide (4) which does not contain the active layer (2a) is doped in a p-conductive fashion with a doping density of $10^{17}$ cm$^{-3}$ to $5 \times 10^{17}$ cm$^{-3}$, in which the lower cladding layer (5) is doped in a p-conductive fashion with a doping density of $5 \times 10^{17}$ cm$^{-3}$ to $2 \times 10^{18}$ cm$^{-3}$, and in which the remaining cladding layers (6, 7) are doped in an n-conductive fashion with a doping density of $5 \times 10^{17}$ cm$^{-3}$ to $5 \times 10^{18}$ cm$^{-3}$.

7. Laser diode according to Claim 6, in which the upper cladding layer (1) is 1 μm to 3 μm thick, in which the active layer (2a) is 0.05 μm to 0.3 μm thick, in which the tuning layer (2t) is 0.05 μm to 0.4 μm thick, in which the cladding layer (3) between the waveguides (2, 4) is 0.1 μm to 0.5 μm thick, and in which the waveguide (4) which does not contain the active layer (2a) is 0.1 μm to 0.7 μm thick.

8. Laser diode according to one of Claims 1 to 7, in which the waveguide (2) which is present only in a coupling region has an interconnected section which is at least three quarters the length of the laser resonator.

**Revendications**

1. Laser à diode accordable,

   dans lequel deux guides d'ondes (2, 4) exécutés en tant que couches, situés verticalement l'un au-dessus de l'autre relativement au plan des couches et séparés l'un de l'autre par une couche d'enveloppe (3), sont si proches l'un de l'autre qu'il se produit un couplage de modes entre ces guides d'ondes (2, 4)
   dans lequel un de ces guides d'ondes (2) est présent seulement dans une zone de couplage qui n'occupe pas toute la longueur d'un segment du laser à diode prévu en tant que résonateur,
   dans lequel ces guides d'ondes (2, 4) ont des dimensions et des compositions de matériau telles qu'un couplage de deux modes différents a lieu dans cette zone de couplage,
   dans lequel la zone de couplage comprend plusieurs segments contigus (12, 14, 16) qui ont des longueurs différentes qui sont chacune des multiples naturels de la longueur de couplage des modes à coupler,
   dans lequel il existe dans ces guides d'ondes (2, 4), dans cette zone de couplage, une couche active et une couche d'accord qui sont situées verticalement l'une par rapport à l'autre relativement au plan des couches et
   dans lequel il existe des moyens grâce auxquels des courants peuvent être injectés séparément l'un de l'autre dans cette couche active et cette couche d'accord.

2. Laser à diode selon la revendication 1,

   dans lequel la couche active est formée par un des guides d'ondes et la couche d'accord est formée par l'autre guide d'ondes,
   dans lequel la couche d'enveloppe (3) située entre les guides d'ondes est dopée en vue de la conduction électrique d'un premier type de conductibilité,

dans lequel des couches de semi-conducteur sont dopées, sur chacun des côtés des guides d'ondes éloignés de cette couche d'enveloppe (3), en vue de la conduction électrique du type de conductibilité opposé, et dans lequel il existe des contacts (Ke, Kn, Ks) qui sont reliés chacun de manière électroconductrice à cette couche d'enveloppe (3) et à ces couches de semi-conducteur, de manière à ce qu'une injection de courant séparée dans les deux guides d'ondes (2, 4) soit possible.

3. Laser à diode selon la revendication 1,

dans lequel la couche active (2a) et la couche d'accord (2t) sont formées par une structure à plusieurs couches dans un des guides d'ondes (2),
dans lequel cette structure en couches comprend une couche de séparation (2s) entre cette couche active (2a) et cette couche d'accord (2t),
dans lequel cette couche de séparation (2s) est dopée en vue de la conduction électrique d'un premier type de conductibilité,
dans lequel des couches de semi-conducteur sont dopées, à chaque fois sur le côté éloigné de la couche de séparation (2s) de la couche active (2a) et de la couche d'accord (2t), en vue de la conduction électrique du type de conductibilité opposé et
dans lequel il existe des contacts (Ke, Kn, Ks) qui sont reliés chacun de manière électroconductrice à cette couche de séparation (2s) et à ces couches de semi-conducteur, de manière à ce qu'une injection de courant séparée dans la couche active (2a) et dans la couche d'accord (2t) soit possible.

4. Laser à diode selon l'une des revendications 1 à 3,

dans lequel les couches d'enveloppe (1, 3, 5, 6, 7) sont faites en InP,
dans lequel les guides d'ondes (2, 4) comprennent au moins des parties de couche en InGaAsP et
dans lequel les deux guides d'ondes (2, 4) ont des compositions différentes.

5. Laser à diode selon l'une des revendications 1 à 4,

dans lequel il existe, sur une couche d'enveloppe inférieure (5), un guide d'ondes (4) en forme de bande situé sur toute la longueur du segment prévu en tant que résonateur à laser,
dans lequel il existe, sur ce guide d'ondes (4), une couche d'enveloppe (3, 6), dans lequel le second guide d'ondes (2) est situé, sous forme de bande, sur cette couche d'enveloppe (3),
dans lequel ce second guide d'ondes (2) est parallèle au premier guide d'ondes (4) et, relativement à la structure en couches, situé verticalement par rapport à celui-ci, et il n'occupe pas toute sa longueur,
dans lequel il existe, sur ce second guide d'ondes (2), une couche d'enveloppe supérieure (1),
dans lequel ces guides d'ondes (2, 4) sont situés entre des couches d'enveloppe latérales (7),
dans lequel des couches de contact (9, 10a, 10b) à haut niveau de dopage sont appliquées sur la couche d'enveloppe supérieure (1) et sur les couches d'enveloppe latérales (7),
dans lequel des contacts (Ke, Kn, Ks) sont appliqués, et
dans lequel ces couches d'enveloppe (1, 3, 5, 6, 7) sont dopées en vue d'une conduction électrique, de manière à ce que ces contacts (Ke, Kn, Ks) soient reliés de manière électroconductrice aux couches d'enveloppe (1, 3, 5, 6) situées verticalement par rapport aux guides d'ondes (2, 4), de telle sorte que des courants puissent être injectés séparément dans une couche active exécutée dans un de ces guides d'ondes (2, 4) et dans une couche d'accord exécutée dans un de ces guides d'ondes (2, 4).

6. Laser à diode selon la revendication 5, rapportée à la revendication 4,

dans lequel la couche active (2a) et la couche d'accord (2t), séparées par une couche de séparation (2s), sont exécutées séparément dans un des guides d'ondes (2),
dans lequel la couche d'enveloppe supérieure (1) est dopée type P, avec une densité de dopage allant de $10^{17}$ cm$^{-3}$ à $10^{18}$ cm$^{-3}$,
dans lequel la couche active (2a) a, au plus, une densité de dopage de $10^{18}$ cm$^{-3}$,
dans lequel la couche de séparation (2s) est dopée type N, avec une densité de dopage allant de $5 \times 10^{17}$ cm$^{-3}$ à $5 \times 10^{18}$ cm$^{-3}$,
dans lequel la couche d'accord (2t) a, au plus, une densité de dopage de $2 \times 10^{18}$ cm$^{-3}$,
dans lequel la couche d'enveloppe (3) entre les guides d'ondes (2, 4) est dopée type P, avec une densité de dopage allant de $2 \times 10^{17}$ cm$^{-3}$ à $2 \times 10^{18}$ cm$^{-3}$,

dans lequel le guide d'ondes (4), qui ne contient pas la couche active (2a), est dopé type P, avec une densité de dopage allant de $10^{17}$ cm$^{-3}$ à $5 \times 10^{17}$ cm$^{-3}$,

dans lequel la couche d'enveloppe inférieure (5) est dopée type P, avec une densité de dopage allant de $5 \times 10^{17}$ cm$^{-3}$ à $2 \times 10^{18}$ cm$^{-3}$, et dans lequel les autres couches d'enveloppe (6, 7) sont dopées type N, avec une densité de dopage allant de $5 \times 10^{17}$ cm$^{-3}$ à $5 \times 10^{18}$ cm$^{-3}$.

7. Laser à diode selon la revendication 6,

dans lequel la couche d'enveloppe supérieure (1) mesure de 1 μm à 3 μm d'épaisseur,

dans lequel la couche active (2a) mesure de 0,05 μm à 0,3 μm d'épaisseur,

dans lequel la couche d'accord (2t) mesure de 0,05 μm à 0,4 μm d'épaisseur,

dans lequel la couche d'enveloppe (3) entre les guides d'ondes (2, 4) mesure de 0,1 μm à 0,5 μm d'épaisseur et dans lequel le guide d'ondes (4), qui ne contient pas la couche active (2a), mesure de 0,1 μm à 0,7 μm d'épaisseur.

8. Laser à diode selon l'une des revendications 1 à 7,
dans lequel le guide d'ondes (2), qui est présent seulement dans une zone de couplage, comprend un segment continu qui couvre au moins trois quarts de la longueur du résonateur à laser.

FIG 1

FIG 2

FIG 3

FIG 4

FIG 5a

FIG 5b

FIG 5c

FIG 6

## FIG 7

## FIG 8